# EUROPEAN PATENT APPLICATION

(11) **EP 2 657 968 A1**
(43) Date of publication of application: **30.10.2013**
(21) Application number: 10857722.2
(22) Date of filing: 11.11.2010
(51) Int. Cl.: H01L 25/13, F21S 2/00, F21V 23/06, F21Y 101/02

(54) **PACKAGE STRUCTURE OF HIGH-POWER LED LIGHT SOURCE MODULE**

(30) Priority: 30.09.2010 CN 201010299568
(71) Applicant: Fujian Zhongkewanbang Photoelectric Shares Co. Ltd, Putian, Fujian 351100 (CN)
(72) Inventor: HE, Wenming, Putian Fujian 351100 (CN)
(74) Representative: Gregersen, Niels Henrik
(86) International application number: PCT/CN2010/078626
(87) International publication number: WO 2012/040959

(57) **Abstract**

A package structure of high-power LED light source module comprises a circuit board (16), LED chips (12), and a pedestal (11) provided with a plurality ofreflective cups (15). The LED chips (12) are stuck at the bottom of the reflective cups (15) by insulating adhesive. The circuit board (16) is embedded in the center of the pedestal (11). An opening (17) is provided at the side wall of each reflective cup (15). The circuit board (16) extends to the opening (17). The LED chips (12) are connected to the circuit board (16) by wires (19). A mixed layer of glue and phosphor is coated above both the LED chips (12) provided in the reflective cups (15) and the circuit boards (16) extending to the opening (17) of the reflective cups (15).

## Description

### Field of the Invention

The present invention refers to a lighting equipment, especially refers to a high-power LED light source module.

### Prior art

LED is a kind of light with low voltage, it has been widely applied in various low-voltage lighting equipments due to its power saving and long lifetime. Traditional package structures of LED light source module commonly comprise a metal substrate with reflective cups, several LED chips installed in the centre of the reflective cups of the pedestal, the LED chips are stuck on the centre of the bottom of the reflective cups uniformly by welding or insulating adhesive; LED chips are extended after being connected in series or in parallel with each other by wires, and are connected to the circuit boards outside the reflective cups of the metal substrate, and then a mixed layer of glue and phosphor is coated on the upper surface of the LED chips so that the LED chips are entirely covered below the mixed layer. In the above-mentioned traditional package structure of LED light source module, lead wires are required between LED chips and the circuit layer, however, LED chips are fixed inside the reflective cup, while the circuit board is configured outside the reflective cup, thus lead wires between LED chips and the circuit layer are easy to be damaged during manufacturing due to impact by human error, which significantly reduces production efficiency, furthermore, the production process becomes more complicated, increasing production cost.

### Technology of the invention

The technical problem to be solved by the present invention is to provide a package structure of LED light source module with simplified production process and saving production cost.

The present invention is achieved through the following structures:
A package structure of high-power LED light source module, comprises a pedestal provided with a plurality of reflective cups, at least one LED chip is mounted at the bottom of the reflective cup, the LED chips are stuck on the bottom of the reflective cups by insulating adhesive, wherein a circuit board is embedded in the centre of the pedestal; an opening is provided at the side wall of the reflective cup, the circuit board extends to the opening of the side wall; the LED chips are connected to the circuit board by wires, and a mixed layer of glue and phosphor is coated above both the LED chips provided in the reflective cups and the circuit boards extending to the opening of the reflective cups.

The circuit board is formed by compressing a layer of fiberglass plate and a circuit layer together, a layer of reflective white paint is coated on the upper surface of the circuit layer.

An electroplated reflective layer is provided on the upper surface of the pedestal.

The pedestal and reflective cups are both round.

There are six reflective cups, and the circuit board is of " 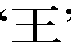 " shape.

The invention has the following merits:
LED chips, circuit board extending to the opening of the reflective cups and wires between them are all encapsulated under the mixed layer of glue and phosphor applying the package structure mentioned above, which could be accomplished in one step during packaging process of LED chips, and it leads to significantly improved production efficiency, reduced damage of wires during production and saving production cost.

### Description of the Drawing

The invention will be further described by embodiments with reference to the accompanying drawings.
Figure 1 is a schematic drawing illustrating the entire structure of the present invention.
Figure 2 is a schematic drawing illustrating the structure between the pedestal, the circuit board and LED chips of the present invention.
Figure 3 is an A-A sectional view of figure 2.
Figure 4 is a B-B sectional view of figure 2.

### Embodiments

The present invention will be disclosed in detailed description with reference to the specific examples.

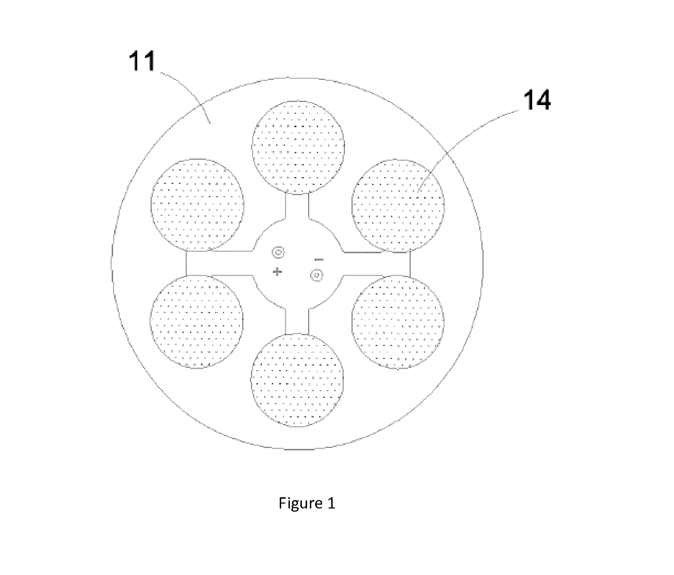

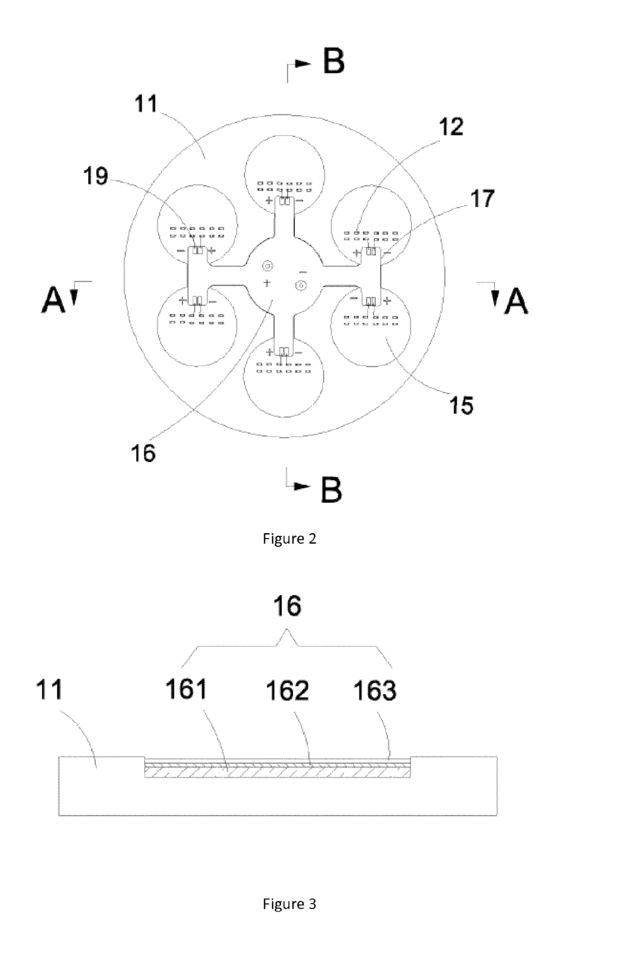

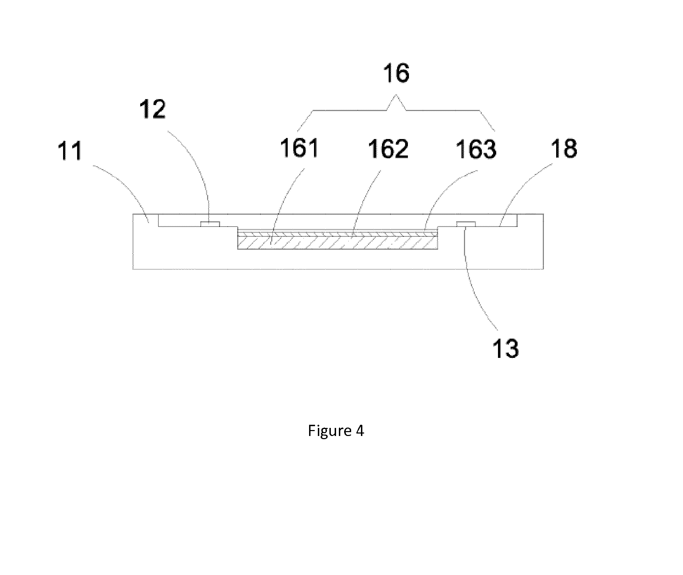

As shown in Figure 1 to 4, it is illustrated the package structure of high-power LED light source module of the present invention, comprising a pedestal 11, LED chips 12, insulating adhesive 13, a mixed layer of glue and phosphor 14, reflective cups 15, circuit boards 16, an opening 17, a reflective layer 18 and wires 19.

There are 6 reflective cups configured symmetrically on the pedestal 11, the pedestal 11 and reflective cups 15 are both round; the pedestal 11 is formed integrally of copper by die-cast molding, a electroplated reflective layer 18 is provided on the upper surface thereof, in the present embodiment the electroplated reflective layer 18 is a silver layer; several LED chips 12 are mounted at the bottom of the reflective cup 15, and these LED chips 12 are stuck on the bottom of the reflective cups 15 by insulating adhesive 13, wherein a circuit board 16 is embedded in the centre of the pedestal 11; an opening 17 is provided at the side wall of reflective cup 15, the circuit board 16 extends to the opening 17 of the side wall; the LED chips 12 are connected to the circuit board 16 by wires 19, and a mixed layer 14 of glue and phosphor is coated above both the LED chips 12 provided in the reflective cups 15 and the circuit boards 16 extending to the opening 17 of the reflective cups 15. The circuit board 16 is of " 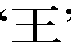 " shape and multi-layer, formed by compressing a layer of fiberglass plate 161 and a circuit layer 162 together, a layer of reflective white paint 163 is coated on the upper surface of the circuit layer 162.

In above embodiments, the pedestal is not limited to be round, it also can be shape of quadrate or strip, etc., which also could achieve the purpose of the invention.

## Claims

1. A package structure of high-power LED light source module comprising a pedestal provided with a plurality of reflective cups, at least one LED chip is mounted at the bottom of the reflective cup, the LED chips are stuck on the bottom of the reflective cups by insulating adhesive, wherein a circuit board is embedded in the centre of said pedestal; an opening is provided at the side wall of said reflective cup, said circuit board extends to the opening of said side wall; said LED chips are connected to said circuit board by wires, and a mixed layer of glue and phosphor is coated above both said LED chips provided in said reflective cups and said circuit boards extending to said opening of the reflective cups.

2. A package structure of high-power LED light source module according to claim 1, wherein said circuit board is formed by compressing of a layer of fiberglass plate and a circuit layer together, a layer of reflective white paint is coated on the upper surface of said circuit layer.

3. A package structure of high-power LED light source module according to claim 1, wherein an electroplated reflective layer is provided on the upper face of said pedestal.

4. A package structure of high-power LED light source module according to claim 1, wherein said pedestal and reflective cups are both round.

5. A package structure of high-power LED light source module according to claim 1, wherein there are six said reflective cups provided, and said circuit board is of " 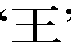 " shape.
